# EUROPEAN PATENT APPLICATION

(11) **EP 1 583 155 A1**
(43) Date of publication of application: **05.10.2005**
(21) Application number: 04700175.5
(22) Date of filing: 05.01.2004
(51) Int. Cl.: H01L 31/042

(54) **TRANSPARENT THIN-FILM SOLAR CELL MODULE AND ITS MANUFACTURING METHOD**

(30) Priority: 10.01.2003 JP 2003003956
(71) Applicant: KANEKA CORPORATION, Osaka-shi, Osaka 530-8288 (JP)
(72) Inventor: NAKATA, Toshinobu, Toyooka-shi, Hyogo 668-0817 (JP); YAMAGISHI, Hideo, Kyoutanabe-shi, Kyoto 610-0300 (JP)
(74) Representative: Vossius & Partner
(86) International application number: PCT/JP2004/000009
(87) International publication number: WO 2004/064167

(57) **Abstract**

A transparent thin-film solar-cell module having high output, high light transmittance, and excellent appearance, the module including a plurality of photoelectric conversion cells connected in series, the cells containing a first electrode layer, a semiconductor layer, and a second electrode layer stacked in that order on a main surface of a transparent insulating substrate; and a plurality of light-transmissive aperture holes formed by removing at least the second electrode layer, the light-transmissive aperture holes each having a diameter of 30 µm to 500 µm, the plurality of light-transmissive aperture holes being disposed in a line at a distance between the centers of the light-transmissive aperture holes of 1.01 to 2 times the diameter of each light-transmissive aperture hole, and a method for producing the module.

## Description

### Technical Field

The present invention relates to a thin-film solar-cell module. In particular, the present invention relates to a transparent thin-film solar-cell module having light transmittance and being usable as a light-transmitting screen, a background being viewable through the module.

### Background Art

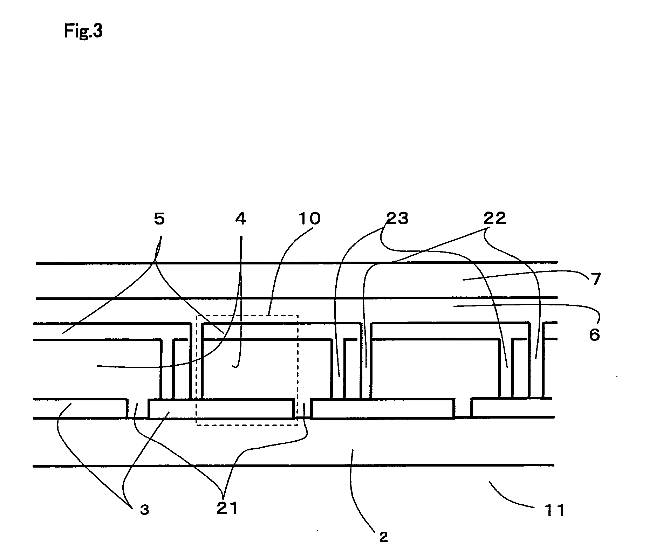

In general, a typical thin-film solar cell often has the structure of an integrated thin-film solar cell 11 shown in Fig. 3. In Fig. 3, a photoelectric conversion cell 10 includes a first electrode layer 3, a semiconductor layer 4, and a second electrode layer 5 stacked in that order on a transparent insulating substrate 2. That is, in the integrated thin-film solar cell 11, light incident on the transparent insulating substrate 2 or the second electrode layer 5 is subjected to photoelectric conversion by a photoelectric conversion unit in the semiconductor layer 4.

The integrated thin-film solar cell 11 shown in Fig. 3 includes first isolation grooves 21, second isolation grooves 22, and connecting grooves 23, which separate the thin films described above. The first and second isolation grooves 21 and 22 and the connecting grooves 23 are parallel to each other and extend in the direction perpendicular to the paper plane in Fig. 3 that is a cross-sectional view.

The first electrode layers 3 corresponding to the respective photoelectric conversion cells 10 are isolated by the respective first isolation grooves 21. The aperture of each first isolation groove 21 is disposed at the interface between the corresponding first electrode layer 3 and semiconductor layer 4, and the bottom of each first isolation groove 21 is the surface of the transparent insulating substrate 2. The first isolation grooves 21 are filled with silicon-based thin films constituting the semiconductor layers 4 and electrically isolate adjacent first electrode layers.

The second isolation grooves 22 are disposed at positions apart from the first isolation grooves 21. The semiconductor layers 4 and the second electrode layers 5 corresponding to the respective photoelectric conversion cells 10 are isolated by the respective second isolation grooves 22. The aperture of each second isolation groove 22 is disposed at the interface between the corresponding second electrode layer 5 and resin sealing layer 6, and the bottom of each second isolation groove 22 is the surface of the corresponding first electrode layer 3. The second isolation grooves 22 are filled with a material constituting the resin sealing layer 6 and electrically isolate adjacent second electrode layers 5 of the photoelectric conversion cells 10.

Each of the connecting grooves 23 is disposed between the corresponding first isolation groove 21 and second isolation groove 22. The semiconductor layers 4 are isolated by the respective connecting grooves 23. The aperture of each connecting groove 23 is disposed at the interface between the corresponding semiconductor layer 4 and second electrode layer 5, and the bottom of each connecting groove 23 is the surface of the first electrode layer 3. The connecting grooves 23 are filled with a conductive material constituting the second electrode layers 5 and electrically connect the second electrode layer 5 in one of the adjacent photoelectric conversion cells 10 with the first electrode layer 3 of the other photoelectric conversion cell 10. That is, the connecting grooves 23 filled with the conductive material function to connect the respective cells 10 in series on the transparent insulating substrate 2.

A region, including each of the connecting grooves 23, between the first and second isolation grooves 21 and 22 does not contribute to photoelectric conversion, and is generally referred to as a "connecting regions 9".

With respect to a transparent solar-cell module, conventionally, a process for providing light-transmissive aperture portions in a cell region functioning as an active region where photoelectric conversion is performed and a process for providing light-transmissive aperture portions outside the cell region have been proposed. In general, in the former process, i.e., in the process for providing the aperture portions in the cell region, the aperture portion can be more densely arranged in the plane of the solar-cell module. Thus, the module has uniform, excellent light transmittance and appearance allover the module.

With respect to the shape of the aperture portions in the module, a repetition of a specific shape, for example, a honeycomb shape has been proposed as the shape of the light-transmissive aperture portions (United States Patent No. 4,795,500). Parallel aperture grooves at equal intervals have been proposed as the light-transmissive aperture portions (United States Patent No. 5,254,179).

Examples of a usable process for forming such aperture portions include laser scribing, wet etching, dry etching, lift-off processing, and wire mask processing. For the thin-film solar-cell module, laser scribing is available in which pulsed laser light scans relatively to the substrate to process the thin films on the substrate, in other words, the thin films on the substrate are patterned. In production of an integrated thin-film solar-cell module, a patterning step for connecting the photoelectric conversion cells in series and a patterning step for forming the light-transmissive aperture portions can be performed by laser scribing with the same apparatus (Japanese Unexamined Patent Application Publication No. 04-348570).

For such a thin-film solar cell, it is common to improve the properties of the solar cell by a method for applying a reverse bias voltage between the first electrode layer and the second electrode layer in one photoelectric conversion cell (referred to as "reverse bias treatment") to remove a short-circuited defective portion in the photoelectric conversion cell near the final step of a process for producing the thin-film solar cell (Japanese Unexamined Patent Application Publication Nos. 2000-277775 and 2001-053302).

When the aperture portions in the module are formed of aperture holes, unless the interval between adjacent aperture holes is satisfactorily small, it is visually recognized that the aperture holes are discontinuous; hence, a background or an image observed via the transparent thin-film solar-cell module has insufficient luminance and resolution and becomes blurry. These are problems. Furthermore, excessively small aperture holes result in a steep reduction in light transmittance. Excessively large aperture holes result in a problem in the appearance and the output of the solar cell.

When the aperture portions in the module are formed of aperture grooves, the second electrode layer in one photoelectric conversion cell is partially removed by the aperture grooves and is thus partitioned into a plurality of sections. Therefore, there is a problem that the "reverse bias treatment" is insufficiently performed.

When the aperture portions in the module are formed of aperture grooves, in order to form the aperture grooves by continuously disposing light-transmissive aperture holes by laser scribing, the distance between adjacent positions irradiated with laser light is required to be smaller than the diameter of each light-transmissive aperture hole to be formed by irradiation with the laser light. This limits the scanning velocity of the laser light.

An increase in the ratio of the light-transmissive aperture holes to the transparent thin-film solar-cell module results in generation of a clear image, but results in reductions in photoelectric conversion properties.

### Disclosure of Invention

As a result of intensive research in consideration of the above-described problems, the present inventors found that, in a transparent thin-film solar-cell module including a multilayer film containing a first electrode layer, a semiconductor layer, and a second electrode layer stacked in that order on a main surface of a transparent insulating substrate; a cell region containing a plurality of photoelectric conversion cells connected in series; and a plurality of light-transmissive aperture holes in the cell region, the plurality of light-transmissive aperture holes being formed by removing at least the second electrode layer, the light-transmissive aperture holes each having a diameter of 30 µm to 300 µm, the plurality of light-transmissive aperture holes being disposed in line so that a distance between the centers of the light-transmissive aperture holes is 1.01 to 2 times the diameter of the light-transmissive aperture hole, definition of the background was improved, and the transparent thin-film solar-cell module had high power and excellent appearance because the reverse bias treatment could be sufficiently performed.

A method for producing such light-transmissive aperture holes by irradiating the multilayer film containing the first electrode layer, the semiconductor layer, and the second electrode layer with laser light, wherein the multilayer film is scanned by the laser light intermittently using a Q-switch.

In view of light transmittance and productivity, in the transparent thin-film solar-cell module, the plurality of light-transmissive aperture holes are preferably disposed in a line at intervals of 1.01 to 1.5 times the diameter of each light-transmissive aperture hole.

To achieve high, uniform light transmittance allover the module, each of the light-transmissive aperture holes preferably has a diameter of 100 µm to 300 µm.

In view of light transmittance and the output of the module, the ratio of the total area of the light-transmissive aperture holes to the area of the cell region is preferably 5% to 30%.

For the appearance of the module, the light-transmissive aperture holes are disposed in the series-connection direction of the photoelectric conversion cells, preferably in a straight line, and more preferably in straight lines parallel to each other at regular intervals.

The above-described transparent thin-film solar-cell module has high reliability by providing a back sealer composed of a fluorocarbon resin or glass, which has high transmittance and weatherability, on the multilayer film.

By performing reverse bias treatment after forming the light-transmissive aperture holes, the transparent thin-film solar-cell module having high conversion efficiency can be produced.

### Brief Description of the Drawings

Fig. 1 is a schematic plan view of a transparent thin-film solar-cell module 1 according to the present invention.
Fig. 2 is a schematic plan view of an aperture portion 18 including isolated light-transmissive aperture holes 8 disposed in a straight line.
Fig. 3 is a schematic cross-sectional view of an integrated thin-film solar cell 11.

### Reference Numerals

- 1: transparent thin-film solar-cell module
- 2: transparent insulating substrate
- 3: first electrode layer
- 4: semiconductor layer
- 5: second electrode layer
- 6: resin sealing layer
- 7: back sealer
- 8: light-transmissive aperture hole
- 9: connecting region
- 10: photoelectric conversion cell
- 11: integrated thin-film solar cell
- 12: integrating direction
- 17: aperture groove including light-transmissive aperture holes 8 continuously disposed in straight line
- 18: aperture portion including isolated light-transmissive aperture holes 8 disposed in straight line
- 21: first isolation groove
- 22: second isolation groove
- 23: connecting groove
- 81: diameter of light-transmissive aperture hole 8
- 82: distance between centers of light-transmissive aperture holes 8

### Best Mode for Carrying Out the Invention

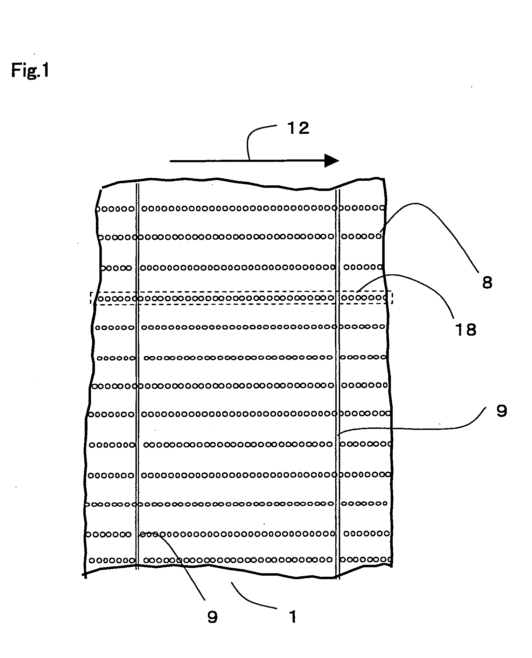

Embodiments of the present invention will be described in detail with reference to Figs. 1, 2, and 3. In these figures of the present invention, the same reference numeral represents the same portion or an equivalent portion. Redundant description is not repeated.

Examples of the transparent insulating substrate 2 which can be used include a glass plate and a transparent resin film. As the glass plate, a float plate glass which has the smooth main surfaces, which is principally composed of SiO₂ Na₂O and CaO, and which has high transparency and high insulation, can be used. A large-area float plate glass is inexpensively available.

When light enters the semiconductor layer 4 from the transparent insulating substrate 2 side, the first electrode layer 3 may be formed of a transparent conductive oxide film such as an indium-tin oxide (ITO) film, a SnO₂ film, or a ZnO film. On the other hand, when light enters the semiconductor layer 4 from the second electrode layer 5 side, the first electrode layer 3 may be formed of a metal layer such as a silver film or an aluminum film. Furthermore, the first electrode layer 3 may have a multilayer structure. The first electrode layer 3 may be formed by known gas-phase deposition such as vapor deposition, chemical vapor deposition (CVD), or sputtering. The first electrode layer 3 preferably has a surface texture structure including fine irregularities. Such a texture structure on a surface of the first electrode layer 3 permits an improvement in the efficiency of light incident on the semiconductor layer 4 constituting a photoelectric conversion unit.

The semiconductor layer 4 may include, for example, a thin-film amorphous photoelectric conversion unit containing an amorphous photoelectric conversion layer or a thin-film crystalline photoelectric conversion unit containing a crystalline photoelectric conversion layer. Furthermore, the semiconductor layer 4 may be a tandem type or a triple type, which include the thin-film amorphous photoelectric conversion unit and the thin-film crystalline photoelectric conversion unit. In this case, the amorphous photoelectric conversion unit may include, for example, p-type silicon semiconductor layer, a non-doped amorphous silicon photoelectric conversion layer, and an n-type silicon semiconductor layer stacked in that order from the side of the first electrode layer 3. The crystalline photoelectric conversion unit may include, for example, a p-type silicon semiconductor layer, a non-doped crystalline silicon photoelectric conversion layer, and an n-type silicon semiconductor layer stacked in that order from the amorphous photoelectric conversion unit. All these semiconductor layers may be formed by plasma-enhanced chemical vapor deposition (CVD).

When light is incident on the transparent insulating substrate 2 side, the second electrode layer 5 functions as not only an electrode but also a reflecting layer that reflects the light, which is incident on the semiconductor layer 4 and then reaches the second electrode layer 5, and that reenters the light into the semiconductor layer 4. The second electrode layer 5 may be formed by, for example, vapor deposition or sputtering with silver, aluminum, or the like. In addition, to improve the adhesiveness between the second electrode layer 5 and the semiconductor layer 4, for example, a transparent conductive thin film (not shown) composed of a nonmetal material such as ZnO may be interposed therebetween. When light is incident on the second electrode layer 5 side, the second electrode layer 5 may be formed of a transparent conductive oxide film such as an ITO film, a SnO₂ film, or a ZnO film.

The above-described transparent thin-film solar-cell module 1 may be produced by the following method.

A first electrode layer 3 is formed on the entirety of a main surface of the transparent insulating substrate 2 and is then irradiated with, for example, YAG fundamental wave laser light to form first isolation grooves 21 partitioning the first electrode layer 3 into rectangular-shaped sections.

A second electrode layer 5 is deposited over the semiconductor layers 4. The connecting grooves 23 are filled with the same metal material as that constituting the second electrode layer during the deposition of the second electrode layer 5. As a result, the second electrode layer 5 and the first electrode layers 3 are electrically connected. The semiconductor layers 4 and the second electrode layer 5 are processed by laser scribing to form second isolation grooves 22.

Next, p-type, i-type, and n-type amorphous silicon films and/or p-type, i-type, and n-type polycrystalline silicon films are stacked in that order at least once over the first electrode layers 3 and the first isolation grooves 21 by, for example, plasma-enhanced CVD to form a semiconductor layer 4. Then, the semiconductor layer 4 is irradiated with, for example, YAG second harmonic laser light to form connecting grooves 23 partitioning the semiconductor layer 4 into rectangular-shaped sections.

Subsequently, for example, a transparent conductive thin film and a metal film are formed in that order over the semiconductor layers 4 and the connecting grooves 23 by, for example, sputtering to form a second electrode layer 5. Then, the second electrode layer 5 are irradiated with, for example, YAG second harmonic laser light from the transparent insulating substrate 2 side to form second isolation grooves 22 partitioning the second electrode layer 5 into rectangular-shaped sections.

Furthermore, for example, the YAG fundamental wave laser light and YAG second harmonic laser light are allowed to be incident on the transparent insulating substrate 2 side and scan the resulting laminate to remove the first electrode layers 3, the semiconductor layers 4, and the second electrode layers 5, thereby isolating the cell region from the periphery of the transparent insulating substrate 2. As a result, insulation of the cell region from the periphery is ensured.

In this way, an integrated thin-film solar cell 11 including a multilayer film containing the first electrode layer 3, the semiconductor layer 4 composed of amorphous and/or polycrystalline silicon semiconductor, and the second electrode layer 5 stacked in that order on a main surface of the transparent insulating substrate 2; and a cell region containing a plurality of photoelectric conversion cells 10 connected in series and a plurality of connecting regions 9, is produced, the plurality of photoelectric conversion cells 10, each having the same rectangular shape, being connected in series.

The YAG second harmonic laser light is allowed to be incident on, for example, the transparent insulating substrate 2 side and scan the resulting integrated thin-film solar cell 11 to form a plurality of light-transmissive aperture holes 8 shown in Fig. 1 by the same process as that for partitioning the back electrode film 5.

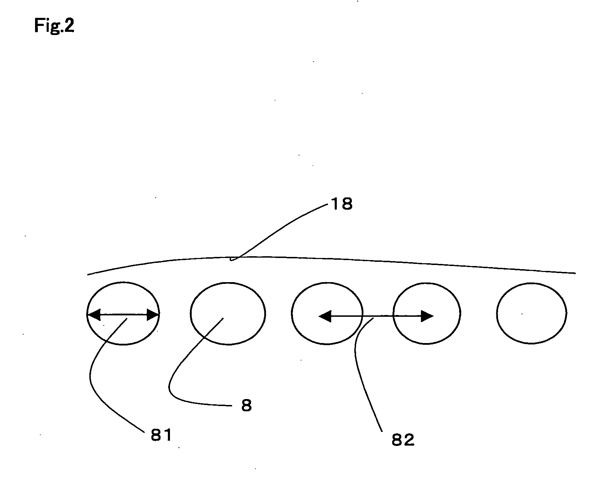

As shown in Fig. 2, the light-transmissive aperture holes 8 are formed so that the discontinuous, isolated light-transmissive aperture holes 8 are disposed in a straight line to form an aperture portion 18. Furthermore, the light-transmissive aperture holes 8 are formed so that a diameter 81 of each hole 8 is 30 µm to 500 µm and the distance 82 between the centers of the holes 8 is 1.01 to 2 times the diameter 81. The aperture holes 8 are substantially disposed in line. Preferably, the aperture holes 8 are substantially disposed in a straight line as described above, from the standpoint of productivity and the like.

When the distance 82 between the centers of the light-transmissive aperture holes 8 is more than twice the diameter 81 thereof, opaque portions between the light-transmissive aperture holes 8 are markedly recognized. When the distance 82 between the centers of the light-transmissive aperture holes 8 is up to twice the diameter 81 thereof, the aperture portion 18 including the discontinuous, isolated light-transmissive aperture holes 8 disposed in a straight line is visually recognized as a continuous light-transmissive groove at a distance of about 5 m. When the distance 82 between the centers of the light-transmissive aperture holes 8 is less than 1.01 times the diameter 81 thereof, the semiconductor layers 4 and the second electrode layers 5 remaining between the light-transmissive aperture holes 8 are strongly affected by heat due to laser scribing, thus resulting in a fragile state in which delamination or the like may occur. Such fragile portions become defects in the photoelectric conversion cell 10, thus causing a reduction in the output of the transparent thin-film solar-cell module 1. The distance 82 between the centers of the light-transmissive aperture holes 8 is more preferably up to 1.5 times the diameter 81 thereof. In this case, the aperture portion 18 including the discontinuous, isolated light-transmissive aperture holes 8 disposed in a straight line is visually recognized as a continuous light-transmissive groove at a distance of about 1 m.

The light-transmissive aperture holes 8 each have a diameter 81 of 30 µm to 500 µm. When the diameter 81 is less than 30 µm, the transparent thin-film solar-cell module 1 has substantially no light transmittance. When the diameter 81 exceeds 500 µm, in laser scribing, a significantly large laser power is required. As a result, an apparatus for emitting laser light and its attendant optical system are very expensive. When the diameter 81 of each light-transmissive aperture hole 8 is in the range of 50 µm to 300 µm, it is possible to perform a practical production, which is more preferable. Most preferably, the diameter 81 of each light-transmissive aperture hole 8 is in the range of 100 µm to 300 µm. The transparent thin-film solar-cell module 1 having sufficient light transmittance can be produced with a pulsed-laser scribing apparatus inexpensively available under optimally-balanced processing conditions.

The area ratio of the total area of the light-transmissive aperture holes 8 to the area of the cell region, that is, the aperture ratio is preferably 1% to 50%. When the aperture ratio is less than 1%, the transparent thin-film solar-cell module 1 has insufficient light transmittance. When the aperture ratio exceeds 50%, the transparent thin-film solar-cell module 1 has insufficient output. The aperture ratio is preferably in the range of 5% to 30%. When the aperture ratio is 5% or more, it is possible to block out direct sunlight on a sunny day and let enough light into the interior. When the aperture ratio is 30% or less, it is possible to ensure the output of the transparent thin-film solar-cell module 1. Most preferably, the aperture ratio is in the range of 10% to 20%. At an aperture ratio of 10% or more, when the transparent thin-film solar-cell module 1 is used as a light-transmitting screen, it is possible to obtain an image having sufficient luminance and resolution. At an aperture ratio of 20% or less, the output of the transparent thin-film solar-cell module 1 is comparable to that of a general solar-cell module.

In connection with the aperture ratio described above, the interval between adjacent aperture portions 18 each including the isolated light-transmissive aperture holes 8 disposed in a line is preferably 0.5 mm to 3 mm so that a background or an image observed via the transparent thin-film solar-cell module has sufficient definition, luminance, and resolution. In consideration of productivity, the interval is particularly preferably 0.8 mm to 1.5 mm.

Laser scribing for forming the light-transmissive aperture holes 8 in the integrated thin-film solar cell 11 can be performed by simultaneously irradiating different portions in the transparent insulating substrate 2 with a plurality of laser beams. If the light-transmissive aperture holes 8 are formed in the entire surface of the transparent insulating substrate 2 by scanning a single laser beam, the scanning time is significantly increased, thus resulting in practical difficulty of the production.

After forming the aperture portion 18 including the isolated light-transmissive aperture holes 8 disposed in a straight line in the integrated thin-film solar cell 11, reverse bias treatment for removing a short-circuited defective portion in the photoelectric conversion cells 10 was performed by applying a reverse bias voltage between the second electrode layers 5 in adjacent photoelectric conversion cells 10.

With respect to specific condition of the reverse bias treatment, in a first step, a 60 Hz sinusoidal wave having an amplitude of 0 to 2 V was applied for 0.1 second. If the peak current value was less than 0.05 A, the treatment was finished. If the peak current value was 0.05 A or more, a voltage in the following step was applied. In a second step, a 60 Hz sinusoidal wave having an amplitude of 0 to 4 V was applied for 0.1 second. If the peak current value was less than 0.05 A, the treatment was finished. If the peak current value was 0.05 A or more, a voltage in the following step was applied. In a third step, a 60 Hz sinusoidal wave having an amplitude of 0 to 6 V was applied for 0.1 second. If the peak current value was less than 0.1 A, the treatment was finished. If the peak current value was 0.1 A or more; a voltage in the following step was applied. In a fourth step, a 60 Hz sinusoidal wave having an amplitude of 0 to 8 V was applied for 0.1 second.

Electrodes for outputting power were provided near the photoelectric conversion cells 10 disposed at both ends. A resin sealing layer 6 composed of a light-transmissive transparent resin and a light-transmissive colorless back sealer 7 stacked in that order over the second electrode layers 5 were subjected to heating and vacuum sealing with a vacuum lamination apparatus. In order to partially transmit sunlight incident on the transparent insulating substrate 2 side to the back sealer 7 side of the transparent thin-film solar-cell module 1 through the light-transmissive aperture holes 8 and in order to allow the transparent thin-film solar-cell module 1 to have sufficient weatherability, the resin sealing layer 6 is preferably composed of, for example, ethylene-vinyl acetate (EVA), and the back sealer 7 is preferably composed of a colorless material such as glass, a fluorocarbon resin, or the like. The solar-cell performance of the resulting transparent thin-film solar-cell module 1 was measured.

### EXAMPLE

The present invention will be described in detail based on several examples and comparative examples. However, the present invention is not limited to the exemplary description below as long as the present invention does not exceed the scope of the gist of the invention.

According to the above-described embodiment, a transparent thin-film solar-cell module 1 was produced including aperture portions 18 containing isolated light-transmissive aperture holes 8 disposed in a straight line.

A SnO₂ film about 700 nm in thickness serving as a transparent conductive film 3 was formed on a glass substrate 2 having an area of 910 mm by 910 mm and a thickness of 5 mm by thermal CVD. The SnO₂ film 3 was subjected to patterning, in other words, the SnO₂ film 3 was irradiated with a YAG fundamental wave laser beam incident on the SnO₂ film 3 side to form first isolation grooves 21. The first isolation grooves 21 each had a width of 60 µm. The interval between the grooves was 8.88 mm. After fine powders and the like due to processing were removed by washing, the glass substrate 2 was transferred into a plasma-enhanced CVD apparatus, and then a photoelectric conversion film about 300 nm in thickness composed of amorphous silicon was formed as a semiconductor layer 4. The glass substrate 2 was transferred from the CVD apparatus, and then the semiconductor layer 4 was irradiated with YAG second harmonic laser light incident on the glass substrate 2 side to form connecting grooves 23. The connecting grooves 23 had a width of 80 µm. The distance between the center lines of adjacent connecting groove 23 and first isolation groove 21 was 170 µm.

A ZnO film about 80 nm in thickness and an Ag film about 300 nm in thickness were formed in that order as a second electrode layer 5 by sputtering on the semiconductor layer 4. By irradiating the second electrode layer 5 with the YAG second harmonic laser light incident on the glass substrate 2 side, the second electrode layer 5 was partitioned into rectangular-shaped sections and second isolation grooves 22 were formed. The second isolation grooves 22 each had a width of 80 µm. The distance between the center lines of adjacent second isolation groove 22 and connecting groove 23 was 170 µm. To insulate cell regions and connecting regions 9 from the periphery of the glass substrate 2, the SnO₂ films 3, the amorphous silicon photoelectric conversion films 4, and the second electrode layers 5 were removed by irradiation with YAG laser light along the periphery of the glass substrate 2. In this way, an integrated thin-film solar cell 11 including 100 photoelectric conversion cells 10, each having a length of 892 mm, connected in series was obtained.

Next, 891 aperture portions 18, each having a length of 888 mm, each including isolated light-transmissive aperture holes 8 disposed in a straight line, and being parallel to the integrating direction 12, were disposed at 1 mm intervals on the integrated thin-film solar cell 11 by irradiation with YAG second harmonic laser light incident on the glass substrate 2 side.

A solder-plated copper foil functioning as an electrode for outputting power was disposed near the photoelectric conversion cells 10 via a plurality of lead-free solder dots that had previously been formed on the glass substrate 2 to form a pair of electrodes on the glass substrate 2. Next, reverse bias treatment was performed by applying a voltage between the second electrode layers 5 of adjacent photoelectric conversion cells 10.

Finally, EVA 6 and a glass plate 7 having a thickness of 3 mm stacked in that order over the second electrode layers 5 were subjected to heating and vacuum sealing with a vacuum lamination apparatus.

The resulting transparent thin-film solar-cell module 1 was irradiated with light with air mass 1.5 spectra (AM 1.5) at a light intensity of 100 mW/cm² using a xenon lamp and a halogen lamp as light sources. The photoelectric conversion properties were measured at 25°C.

### (EXAMPLE 1)

In Example 1, aperture portions 18 each including isolated light-transmissive aperture holes 8 disposed in a straight line were formed by irradiating an integrated thin-film solar cell 11 with laser light incident on the glass substrate 2 side under the following conditions: Q-switching frequency, 1 kHz; power at processing point, 0.30 W; and scanning velocity, 200 mm/s.

The average diameter 81 of the resulting light-transmissive aperture holes 8 was 170 µm. The distance 82 between the centers of the light-transmissive aperture holes 8 was 200 µm. The average length of non-processed opaque portions between the light-transmissive aperture holes 8 was 30 µm. Consequently, a transparent thin-film solar-cell module 1 having an aperture ratio of 11.3% was obtained. With respect to the photoelectric conversion properties, the open-circuit voltage was 88.8 V, the short-circuit current was 1.008 A, the fill factor was 0.609, and the maximum output was 54.5 W.

An image was projected onto the transparent thin-film solar-cell module 1 produced in Example 1 using a commercially available indoor projector 2 m away. The transmitted image was observed as a continuous image from a position 30 cm away and had sufficient resolution and luminance.

### (EXAMPLE 2)

In Example 2, aperture portions 18 each including isolated light-transmissive aperture holes 8 disposed in a straight line were formed by irradiating an integrated thin-film solar cell 11 with laser light incident on the glass substrate 2 side under the following conditions: Q-switching frequency, 1 kHz; power at processing point, 0.30 W; and scanning velocity, 300 mm/s.

The average diameter 81 of the resulting light-transmissive aperture holes 8 was 170 µm. The distance 82 between the centers of the light-transmissive aperture holes 8 was 300 µm. The average length of non-processed opaque portions between the light-transmissive aperture holes 8 was 130 µm. Consequently, a transparent thin-film solar-cell module 1 having an aperture ratio of 7.5% was obtained. With respect to the photoelectric conversion properties, the open-circuit voltage was 89.8 V, the short-circuit current was 1.050 A, the fill factor was 0.612, and the maximum output was 57.7 W.

An image was projected onto the transparent thin-film solar-cell module 1 produced in Example 2 using a commercially available indoor projector 2 m away. The transmitted image was observed as a continuous image from a position 5 m away and had sufficient resolution and luminance.

### (EXAMPLE 3)

In Example 3, aperture portions 18 each including isolated light-transmissive aperture holes 8 disposed in a straight line were formed by irradiating an integrated thin-film solar cell 11 with laser light incident on the glass substrate 2 side under the following conditions: Q-switching frequency, 1 kHz; power at processing point, 0.10 W; and scanning velocity, 100 mm/s.

The average diameter 81 of the resulting light-transmissive aperture holes 8 was 80 µm. The distance 82 between the centers of the light-transmissive aperture holes 8 was 100 µm. The average length of non-processed opaque portions between the light-transmissive aperture holes 8 was 20 µm. Consequently, a transparent thin-film solar-cell module 1 having an aperture ratio of 5.0% was obtained. With respect to the photoelectric conversion properties, the open-circuit voltage was 89.5 V, the short-circuit current was 1.062 A, the fill factor was 0.623, and the maximum output was 59.2 W.

An image was projected onto the transparent thin-film solar-cell module 1 produced in Example 3 using a commercially available indoor projector 2 m away. The transmitted image was observed as a continuous image from a position 30 cm away and had sufficient resolution and luminance.

### (COMPARATIVE EXAMPLE 1)

In Comparative Example 1, aperture portions 18 each including isolated light-transmissive aperture holes 8 disposed in a straight line were formed by irradiating an integrated thin-film solar cell 11 with laser light incident on the glass substrate 2 side under the following conditions: Q-switching frequency, 1 kHz; power at processing point, 0.30 W; and scanning velocity, 400 mm/s.

The average diameter 81 of the resulting light-transmissive aperture holes 8 was 170 µm. The distance 82 between the centers of the light-transmissive aperture holes 8 was 400 µm. The average length of non-processed opaque portions between the light-transmissive aperture holes 8 was 230 µm. Consequently, a transparent thin-film solar-cell module 1 having an aperture ratio of 5.7% was obtained. With respect to the photoelectric conversion properties, the open-circuit voltage was 89.2 V, the short-circuit current was 1.072 A, the fill factor was 0.621, and the maximum output was 59.4 W.

An image was projected onto the transparent thin-film solar-cell module 1 produced in Comparative Example 1 using a commercially available indoor projector 2 m away. It was observed that the transmitted image was discontinuous from a position 5 m away.

### (COMPARATIVE EXAMPLE 2)

In Comparative Example 2, aperture grooves 17 each including light-transmissive aperture holes 8 continuously disposed in a straight line were formed instead of aperture portion 18 including isolated light-transmissive aperture holes 8 disposed in a straight line. Specifically, the aperture grooves 17 each including light-transmissive aperture holes 8 continuously disposed in a straight line were formed by irradiating an integrated thin-film solar cell 11 with laser light incident on the glass substrate 2 side under the following conditions: Q-switching frequency, 1 kHz; power at processing point, 0.30 W; and scanning velocity, 100 mm/s. As a result, 891 aperture grooves 17 were disposed at 1 mm intervals.

In Comparative Example 2, reverse bias treatment was performed before formation of the light-transmissive aperture holes 8.

The average width of the resulting aperture grooves 17 was 170 µm. Consequently, a transparent thin-film solar-cell module 1 having an aperture ratio of 17% was obtained. With respect to the photoelectric conversion properties, the open-circuit voltage was 87.9 V, the short-circuit current was 0.975 A, the fill factor was 0.590, and the maximum output was 50.6 W.

As described above, to impart the function of light transmittance to the transparent thin-film solar-cell module 1, as shown in Examples 1, 2, and 3, the transparent thin-film solar-cell module 1 including the aperture portions 18 containing the isolated light-transmissive aperture holes 8 disposed in a straight line is advantageous. As shown in Comparative Example 1, when the distance, i.e., the interval between the centers of the light-transmissive aperture holes 8, is more than twice the diameter of each light-transmissive aperture hole, it is observed that the light-transmissive aperture holes 8 in the transparent thin-film solar-cell module 1 is discontinuous. Furthermore, a background viewed through the transparent thin-film solar-cell module 1 and a transmitted image obtained by projecting an image onto the module 1 using a projector become blurry.

In addition, it is possible to increase the scanning velocity of laser light 12 compared with the case of the aperture grooves 17 each including the light-transmissive aperture holes 8 disposed continuously as shown in Comparative Example 2. For example, the scanning velocity of the laser light 12 was 100 mm/s in Comparative Example 2, but was 200 mm/s in Example 1. That is, the scanning velocity in Example 1 is twice that in Comparative Example 2. The aperture ratio is decreased from 17% to 11.3% (about 33% of reduction) with an increase in scanning velocity. That is, for example, as a modification of Example 1, even when the number of aperture portions 18 including the isolated light-transmissive aperture holes 8 disposed in a straight line per the transparent thin-film solar-cell module 1 is increased so that the same aperture ratio as that in the Comparative Example is obtained, sufficient productivity can be expected.

Furthermore, in Comparative Example 2, since the integrated thin-film solar cell 21 includes the aperture grooves 17 each containing the light-transmissive aperture holes 8 continuously disposed in a straight line, the second electrode layers 4 each are partitioned. Therefore, a short-circuited defective portion in the photoelectric conversion cell 10 cannot be sufficiently recovered by applying a reverse bias voltage. As a result, the power properties assumed are not sufficiently exhibited. In Examples 1, 2, and 3, the reverse bias treatment can be performed after the light-transmissive aperture holes 8 are formed. Therefore, the open-circuit current and the fill factor are greater than those in Comparative Examples, thus resulting in large photoelectric conversion.

### Industrial Applicability

As described above, according to the present invention, a transparent thin-film solar-cell module, having high output, high light transmittance, and excellent appearance, can be provided, and can be produced with high productivity.

## Claims

1. A transparent thin-film solar-cell module comprising a multilayer film comprising a first electrode layer, a semiconductor layer, and a second electrode layer stacked in that order on a main surface of a transparent insulating substrate; a cell region comprising a plurality of photoelectric conversion cells connected in series; and a plurality of light-transmissive aperture holes in the cell region, the plurality of light-transmissive aperture holes being formed by removing at least the second electrode layer, the light-transmissive aperture holes each having a diameter of 30 µm to 500 µm, the plurality of light-transmissive aperture holes being disposed in a line at a distance between the centers of the light-transmissive aperture holes of 1.01 to 2 times the diameter of each light-transmissive aperture hole.

2. The transparent thin-film solar-cell module according to claim 1, wherein the plurality of light-transmissive aperture holes are disposed in a straight line at intervals of 1.01 to 1.5 times the diameter of each light-transmissive aperture hole.

3. The transparent thin-film solar-cell module according to claim 1 or 2, wherein the light-transmissive aperture holes each have a diameter of 100 µm to 300 µm.

4. The transparent thin-film solar-cell module according to any one of claims 1 to 3, wherein the area ratio of the total area of the light-transmissive aperture holes to the area of the cell region is 5% to 30%.

5. The transparent thin-film solar-cell module according to any one of claims 1 to 4, wherein the light-transmissive aperture holes are disposed in a line parallel to the series-connection direction of the photoelectric conversion cells.

6. The transparent thin-film solar-cell module according to any one of claims 1 to 5, wherein the light-transmissive aperture holes are disposed in lines parallel to each other at regular intervals.

7. The transparent thin-film solar-cell module according to any one of claims 1 to 6, wherein a back sealer is composed of a fluorocarbon resin or glass.

8. A method for producing the transparent thin-film solar-cell module according to claim 1, the method comprising forming the light-transmissive aperture holes by irradiating the multilayer film with laser light, wherein the distance between the centers of adjacent light-transmissive aperture holes disposed in a straight line is determined by the frequency of Q-switching of the laser light and a relative scanning velocity between the transparent insulating substrate and the laser light.

9. A method for producing the transparent thin-film solar-cell module according to claim 1, the method comprising performing reverse-bias treatment after forming the light-transmissive aperture holes.
